# EUROPEAN PATENT APPLICATION

(11) **EP 1 077 473 A2**
(43) Date of publication of application: **21.02.2001**
(21) Application number: 00306700.6
(22) Date of filing: 07.08.2000
(51) Int. Cl.: H01L 21/00

(54) **Method and apparatus for cleaning a surface of a semiconductor wafer**

(30) Priority: 19.08.1999 US 377096
(71) Applicant: LUCENT TECHNOLOGIES INC., Murray Hill, New Jersey 07974-0636 (US)
(72) Inventor: Marshall, Glenn Alan, Northampton, Pennsylvania 18067 (US); Yanders, Kevin Paul, Germansville, Pennsylvania 18053 (US)
(74) Representative: Buckley, Christopher Simon Thirsk

(57) **Abstract**

A method and apparatus for cleaning a surface of a semiconductor wafer includes introducing an additive, such as carbon dioxide, into deionized water to define an electrically conductive rinsing liquid, and rinsing the surface of the semiconductor wafer with the electrically conductive rinsing liquid to clean the surface of the semiconductor wafer and while reducing electrostatic charge build-up thereon. Also, the semiconductor wafer may be rotated, scrubbed and/or treated with vibrational energy introduced into a dispensed stream of the electrically conductive rinsing liquid. The additive is preferably introduced in a sufficient amount to reduce the electrostatic charge build-up on the surface of the semiconductor wafer to less than about 2 volts to thereby protect the circuits and/or devices thereon.

## Description

### Field Of The Invention

The present invention relates to the field of semiconductors, and, more particularly, to semiconductor wafer cleaning.

### Background Of The Invention

Semiconductor devices are built in manufacturing environments known as clean rooms, which are specifically designed for the filtering and elimination of particulate contaminants. Particle control is vital to the success of semiconductor manufacturing and directly affects device yield, as particles adhering to a device surface may ruin an entire microelectronic circuit. Despite the clean manufacturing environment, cleaning steps are generally performed throughout the semiconductor manufacturing operation to remove particles from the wafers upon which the circuits are fabricated.

Cleaning steps are particularly important before critical processes, such as, lithography, and after inherently dirty processes, such as chemical mechanical polishing (CMP). For example, CMP machines typically used for planarizing or smoothing a semiconductor wafer surface employ a polish slurry containing generally sub-micron sized abrasive particles of a material, such as silica or alumina. Hundreds to thousands of these particles, along with particles removed from a wafer itself during polishing, typically may be found on a polished wafer surface.

Cleaning methods common to semiconductor processing include acid rinses, and rinses with deionized water (DI water) or surfactant solutions. Also, cleaning methods include ultrasonic and megasonic cleaning, brush cleaning, or mechanical buffing using such rinses and solutions, and combinations of these. For example, U.S. Patent No. 5,562,778 to Koretsky et al., discloses ultrasonic wafer cleaning using ultrasonic waves incident with a stream of cleaning liquid, such as DI water, while the wafer is rotating about an axis.

Unfortunately, spin scrubbing and rinsing provide an environment for electrostatic charge generation and build-up. In a spinning chamber, the highly insulative DI water shears across wafer surfaces, creating high levels of electrostatic charge. Although electrostatic charge is generated inside most semiconductor process tools, the highest levels occur in spin scrubbing or rinsing environments. Such high level surface voltages, as high as 60 volts for example, can damage the circuits and/or devices (e.g. transistors) produced on the wafers.

Furthermore, charged wafers leaving the spinning chamber immediately attract and bond particles and other airborne contaminants to the wafer surface. Charged wafers leaving the spinning chamber can also cause electrostatic discharge (ESD) if they come too close to a grounded object. The discharge can produce electromagnetic interference (EMI), which affects surrounding production equipment. In the extreme case, an ESD event causes production tool lock-up, where wafers often have to be reprocessed.

Known approaches to reduce electrostatic build-up include lowering the spin speed and/or decreasing the flow rate of the DI water. While these approaches may reduce the severity (e.g. 10-20%) of the electrostatic build-up, this may not be sufficient to avoid damage to the circuits or devices. Thus, such approaches result in increased cleaning times and lower yields.

There is a need for reduced electrostatic build-up during the cleaning or rinsing of semiconductor wafer surfaces to protect the circuits and devices produced thereon. Also, the amount of time cleaning or rinsing should not be increased.

### Summary Of The Invention

In view of the foregoing background, it is therefore an object of the invention to provide a method for cleaning semiconductor wafers which substantially reduces electrostatic charge build-up on the wafer surface and protects the circuits and devices thereon.

Another object of the invention is to provide a method of cleaning semiconductor wafers which substantially reduces electrostatic charge build-up on the wafer surface while not increasing the cleaning time or lowering the wafer yield.

These and other objects, features and advantages in accordance with the present invention are provided by a method of cleaning a surface of a semiconductor wafer including introducing an additive into deionized water to define an electrically conductive rinsing liquid, and rinsing the surface of the semiconductor wafer with the electrically conductive rinsing liquid to clean the surface of the semiconductor wafer and while reducing electrostatic charge build-up thereon. The additive is preferably carbon dioxide gas which reacts with the DI water to create ions in the electrically conductive rinsing liquid. Specifically, the carbon dioxide (CO₂) reacts with the deionized water (H₂O) to create H⁺ and HCO₃- ions. In other embodiments, the additive may comprise other materials.

The rinsing may comprise removing debris from the surface of the semiconductor wafer without a chemical reaction between the electrically conductive rinsing liquid and the surface of the semiconductor wafer. Also, the semiconductor wafer may be rotated, scrubbed and/or treated with vibrational energy introduced into a dispensed stream of the electrically conductive rinsing liquid. The additive may be introduced immediately prior to dispensing. The additive is preferably introduced in a sufficient amount to reduce the electrostatic charge build-up on the surface of the semiconductor wafer to less than about 2 volts.

Objects, features and advantages in accordance with the present invention are also provided by an apparatus for cleaning a surface of a semiconductor wafer. The apparatus preferably includes a first supply for deionized water, a second supply for an additive which produces an electrically conductive rinsing liquid with the deionized water, a holder for mounting the semiconductor wafer thereon, and a dispenser adjacent the holder and connected to the first and second supplies. The dispenser introduces the additive into the deionized water and rinses the surface of the semiconductor wafer with the electrically conductive rinsing liquid to clean the surface of the semiconductor wafer and while reducing electrostatic charge build-up thereon. Again, the additive is preferably carbon dioxide.

The apparatus may include a scrubber for scrubbing the surface of the semiconductor wafer during rinsing, and a drive motor for rotating the holder mounting the semiconductor wafer during rinsing. The dispenser may dispense the electrically conductive rinsing liquid in a stream onto the surface of the semiconductor wafer, and the additive may be introduced immediately prior to dispensing. The apparatus may also include an energy source for introducing vibrational energy into the stream of electrically conductive rinsing liquid. The dispenser may include a valve for regulating an amount of additive introduced into the deionized water to reduce the electrostatic charge build-up on the surface of the semiconductor wafer to less than about 2 volts.

### Brief Description Of The Drawings

FIG. 1 is a flowchart generally illustrating the method steps for cleaning a surface of a semiconductor wafer in accordance with the present invention.
FIGS. 2 and 3 are schematic perspective views of embodiments of an apparatus for cleaning a surface of a semiconductor wafer in accordance with the present invention.

### Detailed Description Of The Preferred Embodiments

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout and prime notation is used to indicate similar elements in alternate embodiments. The dimensions may be exaggerated in the figures for clarity.

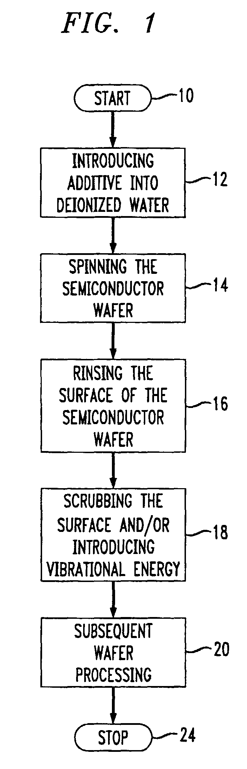

Referring to FIG. 1, the basic steps of the method for cleaning a surface of a semiconductor wafer in accordance with the present invention are now described. In accordance with the present invention, the method begins (Block **10**) and an additive is introduced into a starting liquid to define an electrically conductive rinsing liquid at Block **12**. The starting liquid can be any liquid which is electrically neutral and would not chemically react with the surface of the wafer. The additive can be any element, compound or mixture which reacts with the starting liquid to create ions in the electrically conductive rinsing liquid.

The starting liquid is preferably deionized water (DI water) and the additive is preferably carbon dioxide. Carbon dioxide (CO₂) reacts with deionized water (H₂O) to create H⁺ and HCO₃- ions as would readily be appreciated by those skilled in the art. For example, the flow rates may be 0.2 liters/minute of carbon dioxide to 4 liters/minute of deionized water. The rinsing preferably removes debris from the surface of the semiconductor wafer without chemical reaction between the electrically conductive rinsing liquid and the surface of the semiconductor wafer.

At Block **14**, the semiconductor wafer is rotated, and at Block **16**, the surface of the semiconductor wafer is rinsed with the electrically conductive rinsing liquid. Preferably, the electrically conductive rinsing liquid is dispensed in a stream onto the surface of the semiconductor wafer. The additive may be introduced immediately prior to dispensing. The surface of the semiconductor wafer may be scrubbed with a brush or pad, for example, or vibrational energy may be introduced into the stream of the electrically conductive rinsing liquid (Block **18**). Because the electrically conductive rinsing liquid is conductive, any electrostatic charge build-up on the surface of the semiconductor wafer is reduced. The additive is preferably introduced in a sufficient amount to reduce the electrostatic charge build-up on the surface of the semiconductor wafer to less than about 2 volts. At Block **20**, subsequent wafer processing is performed before ending the process (Block **22**).

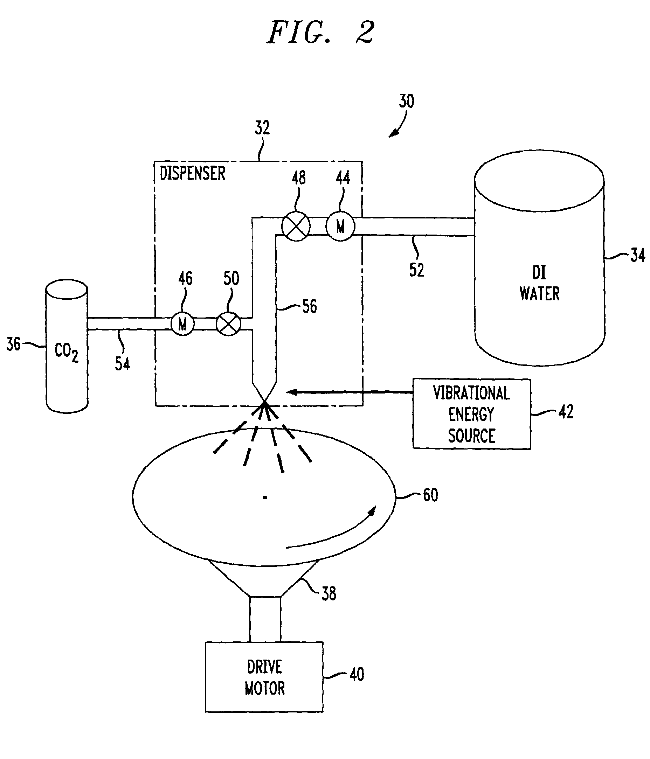

Referring to FIG. 2, an embodiment of the apparatus **30** for cleaning a surface of a semiconductor wafer **60** is now described. The apparatus **30** includes a first supply **34** for a starting liquid, such as deionized water, and a second supply **36** for an additive which produces an electrically conductive rinsing liquid with the deionized water. The semiconductor wafer **60** is mounted on a holder **38**, such as a vacuum chuck or turntable. The holder **38** is connected to a drive motor **40** which spins the wafer **60** during rinsing.

The apparatus **30** includes a dispenser **32** for introducing the additive into the deionized water and for rinsing the surface of the semiconductor wafer **60** with the electrically conductive rinsing liquid to clean the surface of the semiconductor wafer. As mentioned above, the additive reacts with the DI water to create ions in the electrically conductive rinsing liquid, thus, reducing electrostatic charge build-up on the surface of the semiconductor wafer. For example, carbon dioxide (CO₂) reacts with deionized water (H₂O) to create H⁺ and HCO₃- ions.

The dispenser **32** is illustratively connected to the first supply **34** of DI water through a supply line **52**, and the dispenser includes a flow meter **44** and a valve **48** for regulating the flow of DI water. The dispenser **32** is connected to the second supply **36** through supply line **54**, and the dispenser includes a flow meter **46** and valve **50** for regulating the flow of the additive into the DI water. The dispenser **32** regulates an amount of additive introduced into the deionized water to reduce the electrostatic charge build-up on the surface of the semiconductor wafer **60** to less than about 2 volts, preferably, to less than about 1 volt.

The dispenser **32** also includes a nozzle **56** for dispensing the electrically conductive rinsing liquid. The nozzle **56** dispenses the electrically conductive rinsing liquid in a stream onto the surface of the semiconductor wafer **60**. As illustrated, the additive may be introduced immediately prior to dispensing.

Referring specifically to FIG. 2, a first embodiment of the apparatus **30** includes a vibrational energy source **42** for introducing vibrational energy into the stream of electrically conductive rinsing liquid. Such vibrational energy is typically ultrasonic or megasonic waves created with a transducer.

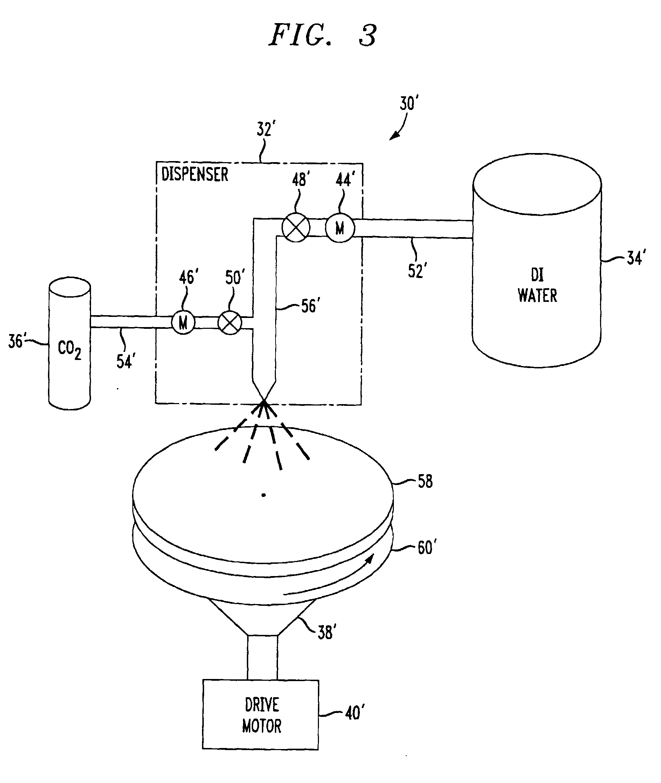

Referring to FIG. 3, another embodiment of the apparatus **30**' includes a scrubbing pad **58**, or brush, which is usually rotated in an opposite direction of the rotation of the wafer **60**'. The other components of the apparatus **30**' are indicated with prime notation and correspond to components described above with reference to FIG. 2. These components need no further discussion herein. The vibrational energy source **42** (FIG.2) and the scrubbing pad **58** (FIG. 3) may also be used together in other embodiments as would be appreciated by the skilled artisan.

Spin scrubbing and sonic rinsing can increase electrostatic charge generation and build-up. As the highly insulative DI water shears across the wafer **60**' surface, the scrubbing pad **58** counter rotates and creates high levels of electrostatic charge. Such high level surface voltages, as high as 60 volts for example, can damage the circuits and/or devices produced on the wafer **60**'. Furthermore, such a charged wafer would immediately attract and bond particles and other airborne contaminants to the wafer surface during subsequent wafer processing, and may also cause electrostatic discharge if it came too close to a grounded object.

In the present invention, the electrically conductive rinsing liquid reduces electrostatic charge build-up on the surface of the semiconductor wafer **60**. Thus, the circuits and/or devices produced on the wafer **60** are protected from high level electrostatic voltages. Furthermore, electrostatic build-up is reduced without increasing the time necessary for cleaning or lowering the wafer yield.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the appended claims.

## Claims

1. A method of cleaning a surface of a semiconductor wafer comprising the steps of:
introducing an additive into deionized water to define an electrically conductive rinsing liquid; and
rinsing the surface of the semiconductor wafer with the electrically conductive rinsing liquid to clean the surface of the semiconductor wafer and while reducing electrostatic charge build-up thereon.

2. A method according to Claim 1, wherein the additive comprises carbon dioxide which reacts with the deionized water to create H⁺ and HCO₃ - ions.

3. A method of cleaning a surface of a semiconductor wafer comprising the steps of:
rotating the semiconductor wafer;
introducing carbon dioxide into deionized water to define an electrically conductive rinsing liquid; and
rinsing the surface of the rotating semiconductor wafer with the electrically conductive rinsing liquid to clean the surface of the semiconductor wafer and while reducing electrostatic charge build-up thereon.

4. A method according to Claim 3, wherein the carbon dioxide reacts with the deionized water to create H⁺ and HCO₃ - ions.

5. A method of cleaning a surface of a semiconductor wafer comprising the steps of:
introducing an additive into a starting liquid to define an electrically conductive rinsing liquid, the starting liquid being electrically neutral and chemically non-reactive with the surface of the semiconductor wafer; and
rinsing the surface of the semiconductor wafer with the electrically conductive rinsing liquid to clean the surface of the semiconductor wafer and while reducing electrostatic charge build-up thereon.

6. A method according to Claim 1,3 or 5, wherein the step of introducing comprises introducing, as the case may be, the carbon dioxide or the additive to create ions in, as the case may be, the deionised water or the starting liquid.

7. A method according to Claim 1 or 5, wherein the additive reacts with the deionised water or the starting liquid, as the case may be, to define the electrically conductive rinsing liquid.

8. A method according to Claim 1 or 5, wherein the step of introducing the additive comprises introducing a gas which reacts with, as the case may be, the deionised water or the starting liquid to create ions in the electrically conductive rinsing liquid.

9. A method according to Claim 5, wherein the additive comprises carbon dioxide.

10. A method according to Claim 5, wherein the starting liquid comprises deionized water.

11. A method according to Claim 1,3 or 5, wherein the step of rinsing comprises removing debris from the surface of the semiconductor wafer without a chemical reaction between the electrically conductive rinsing liquid and the surface of the semiconductor wafer.

12. A method according to Claim 1 or 5, further comprising the step of rotating the semiconductor wafer.

13. A method according to Claim 1, 3 or 5, further comprising the step of scrubbing the surface of the semiconductor wafer during rinsing.

14. A method according to Claim 1,3 or 5, wherein the step of rinsing comprises dispensing the electrically conductive rinsing liquid in a stream onto the surface of the semiconductor wafer.

15. A method according to Claim 14, wherein the step of introducing comprises introducing, as the case may be, the additive or the carbon dioxide immediately prior to dispensing.

16. A method according to Claim 14, further comprising the step of introducing vibrational energy into the stream of electrically conductive rinsing liquid.

17. A method according to Claim 1,3 or 5, wherein the step of introducing comprises introducing, as the case may be, the additive or the carbon dioxide in a sufficient amount to reduce the electrostatic charge build-up on the surface of the semiconductor wafer to less than about 2 volts.

18. An apparatus for cleaning a surface of a semiconductor wafer, the apparatus comprising:
a first supply for a starting liquid which is electrically neutral and chemically non-reactive with the surface of the semiconductor wafer;
a second supply for an additive which produces an electrically conductive rinsing liquid with the deionized water;
a holder for mounting the semiconductor wafer thereon; and
a dispenser adjacent the holder and connected to the first and second supplies for introducing the additive into the deionized water and for rinsing the surface of the semiconductor wafer with the electrically conductive rinsing liquid to clean the surface of the semiconductor wafer and while reducing electrostatic charge build-up thereon.

19. An apparatus according to Claim 18, further comprising a scrubber for scrubbing the surface of the semiconductor wafer during rinsing.

20. An apparatus according to Claim 18, further comprising a drive motor for rotating the holder mounting the semiconductor wafer during rinsing.

21. An apparatus according to Claim 18, wherein the additive comprises carbon dioxide.

22. An apparatus according to Claim 18, wherein the starting liquid comprises deionized water.

23. An apparatus according to Claim 18, wherein the dispenser is for dispensing the electrically conductive rinsing liquid in a stream onto the surface of the semiconductor wafer.

24. An apparatus according to Claim 23, wherein the dispenser is for introducing the additive immediately prior to dispensing.

25. An apparatus according to Claim 23, further comprising an energy source for introducing vibrational energy into the stream of electrically conductive rinsing liquid.

26. An apparatus according to Claim 18, wherein the dispenser includes at least one valve for regulating an amount of additive introduced into the deionized water to reduce the electrostatic charge build-up on the surface of the semiconductor wafer to less than about 2 volts.
